(19) Europäisches Patentamt
European Patent Office
Office européen des brevets

(11) **EP 3 436 618 B1**

(12) **EUROPEAN PATENT SPECIFICATION**

(45) Date of publication and mention
of the grant of the patent:
**03.05.2023 Bulletin 2023/18**

(21) Application number: **17776421.4**

(22) Date of filing: **28.03.2017**

(51) International Patent Classification (IPC):
*C23C 14/34* (2006.01)     *H01J 37/34* (2006.01)
*C23C 4/123* (2016.01)     *C23C 4/134* (2016.01)
*C23C 24/00* (2006.01)     *B33Y 10/00* (2015.01)
*B33Y 80/00* (2015.01)     *C23C 14/14* (2006.01)
*C23C 4/129* (2016.01)     *C23C 4/131* (2016.01)
*C23C 24/10* (2006.01)

(52) Cooperative Patent Classification (CPC):
**H01J 37/3435; B33Y 10/00; B33Y 80/00;
C23C 4/129; C23C 4/131; C23C 4/134;
C23C 14/14; C23C 14/3407; C23C 14/3414;
C23C 24/00; C23C 24/103; C23C 24/106;
H01J 37/3426**

(86) International application number:
**PCT/US2017/024440**

(87) International publication number:
**WO 2017/172692 (05.10.2017 Gazette 2017/40)**

(54) **SPUTTERING TARGET ASSEMBLY HAVING A GRADED INTERLAYER AND METHODS OF MAKING**

SPUTTERTARGETANORDNUNG MIT ABGESTUFTER ZWISCHENSCHICHT UND VERFAHREN ZUR HERSTELLUNG

ENSEMBLE FORMANT CIBLE DE PULVÉRISATION CATHODIQUE AVEC COUCHE INTERMÉDIAIRE GRADUÉE ET PROCÉDÉS DE FABRICATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **01.04.2016   US 201662316701 P
27.03.2017   US 201715470581**

(43) Date of publication of application:
**06.02.2019   Bulletin 2019/06**

(73) Proprietor: **Honeywell International Inc.
Morris Plains, NJ 07950 (US)**

(72) Inventors:
• **FERRASSE, Stephane**
**Morris Plains, NJ 07950 (US)**
• **STROTHERS, Susan D.**
**Morris Plains, NJ 07950 (US)**
• **SHI, Xinlin**
**Morris Plains, NJ 07950 (US)**
• **MORALES, Diane L.**
**Morris Plains, NJ 07950 (US)**

(74) Representative: **Stepney, Gregory John et al
Withers & Rogers LLP
2 London Bridge
London SE1 9RA (GB)**

(56) References cited:
WO-A1-00/06793          JP-A- H0 681 143
US-A- 5 988 488          US-A1- 2004 262 157
US-A1- 2006 065 517      US-A1- 2006 065 517
US-A1- 2008 063 889      US-A1- 2008 197 017
US-A1- 2014 141 264      US-B1- 6 619 537

**Description**

RELATED APPLICATION

TECHNICAL FIELD

The present disclosure relates to sputtering target assemblies and components for use with sputtering targets in physical vapor deposition systems. The present disclosure also relates to sputtering target assemblies and components made using additive manufacturing processes.

BACKGROUND

WO00/06793A1 describes a tantalum sputtering target assembly.
US2006/065517A1 describes sputter target assemblies including a single, or multiple, layered interlayer between the target and backing plate. US6619537B1 describes a sputter target assembly including a high purity copper sputter target diffusion bonded to a backing plate.

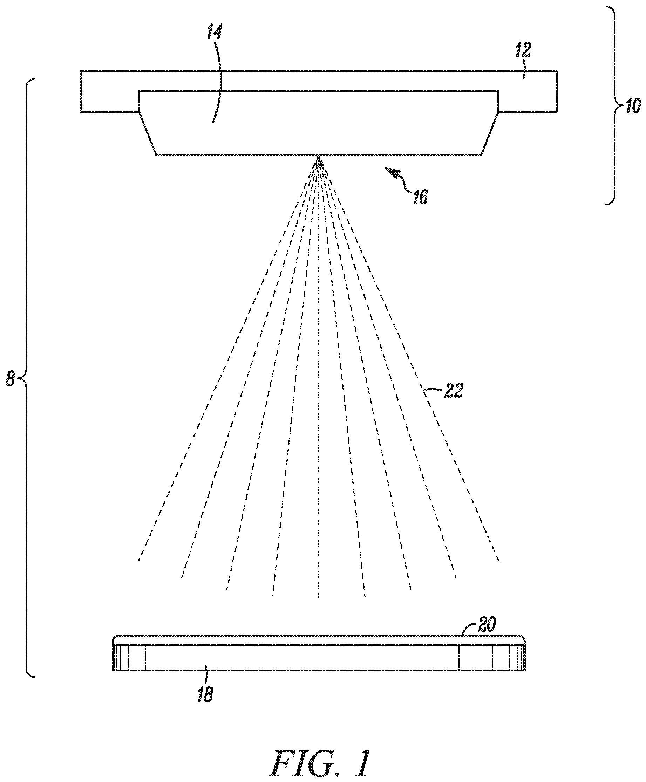

Physical vapor deposition methodologies are used extensively for forming thin films of material over a variety of substrates. One area of importance for such deposition technology is semiconductor fabrication. A diagrammatic view of a portion of an exemplary physical vapor deposition ("PVD") apparatus 8 is shown in FIG. 1. In one configuration, a sputtering target assembly 10 comprises a backing plate 12 having a target 14 bonded thereto. A substrate 18 such as a semiconductive material wafer is within the PVD apparatus 8 and provided to be spaced from the target 14. A surface 16 of target 14 is a sputtering surface. As shown, the target 14 is disposed above the substrate 18 and is positioned such that sputtering surface 16 faces substrate 18. In operation, sputtered material 22 is displaced from the sputtering surface 16 of target 14 and used to form a coating (or thin film) 20 over substrate 18. In some embodiments, suitable substrates 18 include wafers used in semiconductor fabrication.

In an exemplary PVD process, the target 14 is bombarded with energy until atoms from the sputtering surface 16 are released into the surrounding atmosphere and subsequently deposit on substrate 18. In one exemplary use, plasma sputtering is used to deposit a thin metal film onto chips or wafers for use in electronics.

The target 14 may be formed from any metal suitable for PVD deposition processes. For example, the target 14 may include aluminum, vanadium, niobium, copper, titanium, tantalum, tungsten, ruthenium, germanium, selenium, zirconium, molybdenum, hafnium, and alloys and combinations thereof. When such exemplary metals or alloys are intended to be deposited as a film onto a surface, a target 14 is formed from the desired metal or alloy, from which metal atoms will be removed during PVD and deposited onto the substrate 18.

The backing plate 12 may be used to support the target 14 during the PVD deposition process. As discussed herein, a PVD deposition process may cause undesirable physical changes to a sputtering target assembly 10 including the target 14, and backing plate 12. For example, the PVD deposition process may include high temperatures which would cause the target 14 to warp or deform. To prevent this, the sputtering target assembly 10 and components may be designed to reduce these undesirable physical changes. For example, the backing plate 12 may be constructed to have a high heat capacity and/or heat conductivity, which can minimize or prevent undesirable physical changes to the target 14 and sputtering target assembly 10.

One option for tailoring the properties of the sputtering target assembly 10 includes controlling how the backing plate 12 is formed. This may include selection of the backing plate materials used and how the materials are treated during the manufacturing process. Another option includes controlling the assembly of the backing plate 12 and the methods used to form the various components of the backing plate 12.

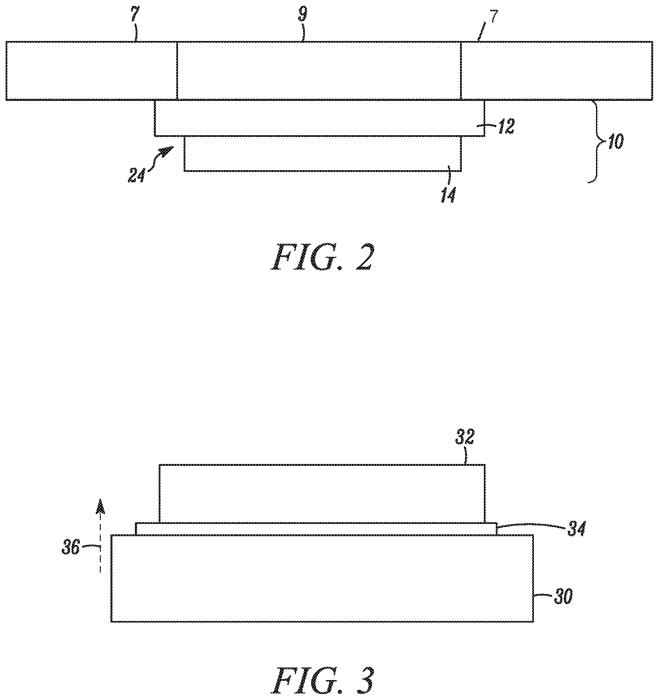

In an example two-component sputtering target assembly 10 design, as illustrated in FIG. 2, a backing plate 12 is formed as a separate component from the target 14. The backing plate 12 as shown is a single solid plate. The target 14 is joined to the backing plate 12 by techniques such as fastening, welding, soldering and diffusion bonding to form a sputtering target assembly 10. The backing plate 12 provides a variety of functions that include strengthening of mechanical properties and enhancement of physical properties of the whole sputtering target assembly 10. The sputtering target assembly 10 as shown in FIG. 2 includes the target 14 and the backing plate 12 after the two have been joined. The target assembly 10 is attached to a PVD system at mounting component 9 by techniques such as fastening with bolts or screws. Additionally, in some embodiments, cooling water 7 directly contacts backing plate 12.

One method of joining a target 14 to a backing plate 12 is by diffusion bonding the two components together. In diffusion bonded targets, bonding of some target and backing plate materials is difficult because of the large difference in the coefficient of thermal expansion (CTE) between the target material and backing plate material. For example, in diffusion bonded targets, bonding some target materials, for example tungsten, to conventional backing plate materials such as aluminum, aluminum alloy, copper, or copper alloy backing plates is difficult because of the large difference in the CTE between these materials.

If an object is made by joining together two bodies of metals having a difference in the CTE, de-bonding or even cracking may occur when the object is heated, for example during bonding or when use in a high temperature environment such as PVD. As an example, when creating a sputtering target assembly 10 as in FIG. 2, thermal stresses can build up at the interface 24 after bonding the target 14 to the backing plate 12 during the cooling phase when the materials are physically connected by a solid state bond but contract at a different rate.

Generally thermal stress in a system having multiple materials is proportional to the difference in CTE between the materials in the system. The relationship between thermal stress ($\sigma$), as a function of temperature (T), and the value of the difference in CTE ($\Delta$CTE, also called CTE mismatch) can be shown using equation 1:

$$\text{Equation 1:} \qquad\qquad\qquad \sigma \sim \Delta CTE * T$$

Thus for materials having a large CTE mismatch, elevated temperatures will produce increased thermal stress on the system.

Some approaches to reduce local stresses include: (i) using lower temperatures for bonding or low temperature bonding technologies such as soldering or nanobonding, (ii) spreading the stresses by using a thin interlayer of a soft, ductile material such as Al to bond a tungsten (W) target with a copper (Cu) alloy backing plate, (iii) using an interlayer of a material having a CTE between the CTE of the target material and the backing plate material to produce a CTE gradient.

The first approach is limited by the bond strength that can be achieved, generally less than 6 ksi. High temperature is usually needed to obtain acceptable and uniform bond strengths, which are typically greater than 6 ksi especially for larger target configurations such as 300 mm targets and 450 mm targets (i.e. targets for use in 300 mm or 450 mm silicon wafer deposit processes.)

The second approach can potentially be unsuccessful when there is a large difference between the CTE of the backing plate and the CTE of the interlayer; and especially when bonding brittle material to a backing plate made from more ductile material. This is more pronounced when one material has a higher coefficient of thermal expansion which may exacerbate the problem of CTE mismatch.

The third approach is typically useful, but is limited to the metals and alloys that have a sufficiently high melting point and also have a coefficient of thermal expansion between that of the target material and that of the backing plate material. An additional consideration is the cost. Materials that have a coefficient of expansion between common pairings of target materials and backing plate materials, such as copper (Cu) and tungsten (W), are usually expensive (for example molybdenum (Mo), niobium (Nb), cobalt (Co), nickel (Ni), tantalum (Ta), beryllium (Be), zirconium (Zr)) and not always commercially available.

What is needed is a method for bonding a target to a backing plate which is an improvement over the foregoing.

SUMMARY

In some embodiments a sputtering target assembly includes a sputtering target having a rear surface, a backing plate having a front surface, and an interlayer disposed between the target and the backing plate. The interlayer includes a first layer disposed proximate the target material rear surface, and a second layer disposed proximate the backing plate front surface. The first layer is formed of a first mixture containing a first material and a second material and having a higher concentration of the first material than the second material, and the second layer is formed of a second mixture containing the first material and the second material and having a higher concentration of the second material than the first material.

In some embodiments, a method of forming a sputtering target assembly includes forming a first layer on a surface of a sputtering target or a surface of a backing target from a first mixture containing a first material and a second material. A second layer is formed on the first layer from a second mixture containing the first material and the second material. The first layer has a higher concentration of the first material than the second layer, and the second layer has a higher concentration of the second material than the first layer. The backing plate or sputtering target is arranged on the second layer to form an assembly having the first layer and second layer between the sputtering target and backing plate, and the sputtering target, the first layer, the second layer, and the backing plate are joined together in a target assembly bonding step.

While multiple embodiments are disclosed, still other embodiments of the present invention will become apparent to those skilled in the art from the following detailed description, which shows and describes illustrative embodiments of the invention. Accordingly, the drawings and detailed description are to be regarded as illustrative in nature and not restrictive.

BRIEF DESCRIPTION OF THE DRAWINGS

FIG. 1 is a schematic illustration of a sputtering apparatus.

FIG. 2 is a schematic illustration of a sputtering target assembly.

FIG. 3 is a schematic illustration of a sputtering target assembly having an interlayer.

FIG. 4 is a schematic illustration of an additive manufacturing system using direct energy deposition.

FIG. 5 is a schematic illustration of an additive manufacturing system using direct energy deposition, in accordance with some embodiments.

FIG. 6 is a schematic illustration of an additive manufacturing system using direct energy deposition, in accordance with some embodiments.

FIG. 7 is a schematic illustration of an additive manufacturing system using direct energy deposition, in accordance with some embodiments.

FIG. 8 is a schematic illustration of an additive manufacturing system using direct energy deposition, in accordance with some embodiments.

FIG. 9 is a schematic illustration of an additive manufacturing system using sheet lamination, in accordance with some embodiments.

FIG. 10 is an illustration of a method of additive manufacturing using sheet lamination, in accordance with some embodiments.

FIG. 11 is a schematic illustration of an additive manufacturing system using ink jetting, in accordance with some embodiments.

FIG. 12 is a schematic illustration of an additive manufacturing system using powder bed diffusion, in accordance with some embodiments.

FIG. 13 is a schematic illustration of a cold spray system, in accordance with some embodiments.

FIG. 14 is a schematic illustration of a plasma spray system, in accordance with some embodiments.

FIGS. 15A and 15B are diagrams of methods of creating a sputtering target assembly interlayer, according to some embodiments.

FIG. 16 is a diagram of a method of creating a sputtering target assembly interlayer, according to some embodiments.

FIG. 17 is a diagram of a method of creating a sputtering target assembly interlayer, according to some embodiments.

FIG. 18 is an illustration of an additive manufacturing produced material having a gradient in the material.

FIG. 19 is an illustration of an additive manufacturing produced material having a gradient in the material.

FIG. 20a and FIG. 20b are photographs of an additive manufacturing produced material having a gradient in the material.

FIG. 21 is a photograph of an additive manufacturing produced material having a gradient in the material.

FIG. 22 is a photograph of an additive manufacturing produced material having a gradient in the material.

DETAILED DESCRIPTION

Additive manufacturing (AM) can be used to create graded materials and therefore materials having graded properties, including physical properties such as electrical and thermal conductivity, and material properties, like CTE, ductility, brittleness and strength (yield or ultimate tensile strength). AM can be used to form components that make up a sputtering target assembly that have a property gradient.

In some embodiments, creating a material having a property gradient such as a gradient in ductility, strength, or CTE can be used to bond a target and backing plate with dissimilar CTEs. In some embodiments, creating a material having a property gradient such as a gradient in ductility, strength, or CTE in a small region near the bonded interface between the target material and backing plate material provides a solution to bonding of materials with dissimilar CTE (i.e. a large CTE mismatch).

As shown in FIG. 3, in some embodiments, a backing plate 30 may be joined to a sputtering target 32 with an interlayer 34 having a property gradient. The backing plate 30 and sputtering target 32 can be arranged in any suitable design. For example, the sputtering target 32 and the backing plate 30 may each be substantially planar as shown in FIG. 3. In other embodiments, the target assembly may have an embedded design in which a portion of the sputtering target 32 fits within a recess or cavity formed in the backing plate 30. The interlayer 34 may have a property gradient in the direction indicated by the arrow 36, which is along an axis extending through the sputtering target 32 and the backing plate 30 and is generally perpendicular to the plane of the sputtering surface.

In some embodiments, the interlayer 34 having a tailored property gradient can be created by depositing material directly by AM on top of either the backing plate 30 or sputtering target 32 or on both the sputtering target 32 and backing plate 30. After depositing the interlayer 34, the backing plate 30 and the sputtering target 32 assembled such that the interlayer 34 is positioned between the backing plate 30 and the sputtering target 32 and the assembly is bonded together.

In one example, the interlayer 34 can be formed on the sputtering target 32 or the backing plate 30. For example, in some embodiments, a first layer formed of a first mixture of a first material and a second material is formed on the back surface of the sputtering target 32. A second layer formed of a second mixture of the first material and the second material may subsequently be formed on top of the first layer. The first layer has a higher concentration of the first material than the second layer, and the second layer has a higher concentration of the second material than the first layer. Backing plate 30 may then be arranged on top of the second layer such that the front surface of the backing plate 30 is adjacent to the second layer. Sputtering target 32, the first layer, the second layer, and backing plate 30 may then be joined together in a bonding step.

In some embodiments, an entire interlayer 34 with the tailored property gradient can be created first and later positioned and bonded between the sputtering target 32 and backing plate 30.

In some embodiments, the backing plate 30 and the sputtering target 32 have one or more different properties and the property gradient of the interlayer smooths or reduces the difference in the property from the backing plate 30 to the sputtering target 32. For example, the interlayer 34 may be comprised of multiple layers and each layer may be from about 0.5 millimeter (0.02 inches) to about 3 millimeters (0.1 inches) thick. In some embodiments, the interlayer 34 is comprised of multiple layers such that the interlayer 34 is from about 1 millimeter (0.04 inches) to about 10 millimeters (0.4 inches) thick. At least one property of adjacent layers may be varied such that the property of the layer adjacent to the sputtering target 32 is more similar to that of the sputtering target 32 and the property of the layer adjacent the backing plate 30 is more similar to that of the backing plate 30. In this way, the interlayer 34 can have a property gradient.

In one example, the backing plate 30 and the sputtering target 32 have different CTEs. For example, the backing plate 30 may be made from backing plate material such as aluminum (Al) and copper (Cu) alloys, which have high CTEs, and the sputtering target 32 may be made from material with low a CTE, for example tungsten (W). In this example system, an interlayer 34 may be made from a material or combination of materials having a high CTE on the side adjacent to the backing plate 30 and gradually change to a material or combination of materials having a lower CTE on the side facing the sputtering target. The material composition at each location in the interlayer 34 is chosen to create an interlayer 34 material having a gradually changing CTE in a direction perpendicular to the plane of the sputtering surface of the sputtering target 32, which may reduce or eliminate stress and fracture in the target assembly. In other embodiments, the interlayer 34 may be made from a material or combination of materials that gives it a low CTE at the side adjacent to the sputtering target 32 and a high CTE at the side adjacent to the backing plate 30. Such an interlayer, for example, may be used when the sputtering target 32 has a lower CTE than the backing plate 30.

As used here, a property gradient refers to change in a compositional or material property from a first location to a second location. Example properties include elemental composition, coefficient of thermal expansion, brittleness, ductility, grain size, grain texture, and material component density.

AM provides several ways to create a material having a property gradient such as a gradient in composition, a, gradient in material component density, a gradient in grain size, a gradient in CTE, a gradient in ductility, and/or a gradient in grain texture. In some embodiments, AM techniques can be used to produce layers of material with varying compositions and densities which enhance the bonding of certain materials together, such as, for example, materials having differing coefficients of thermal expansion (CTE). Depending on the AM method used to create the property gradient, the material property may gradually change in either a substantially smooth or a stepwise manner. Using AM techniques described herein, the layers of material can be built on the backing plate, the target material, or both.

For example, in some embodiments, the sputtering target 32 is formed of a sputtering target material and a coefficient of thermal expansion of a first layer is within five hundred percent of the coefficient of thermal expansion of the sputtering target material. The backing plate 30 is formed of a backing plate material and a coefficient of thermal expansion of a second layer is within five hundred percent of the coefficient of thermal expansion of the backing plate material. In one embodiment, the coefficient of thermal expansion of either the first layer and the second layer may be less than three hundred percent of the coefficient of thermal expansion of the sputtering target material and the backing plate material, respectively.

There are various AM techniques that can be used to carry out the methods of the instant disclosure. Because the material is deposited or laid down in a predetermined pattern and composition, the portion of the instant disclosure that uses AM can be referred to as a printing step. The AM or printing step may employ any one of a variety of AM techniques such as directed energy deposition (DED), sheet lamination, powder bed fusion, ink jetting, cold spray, thermal spray, or plasma spray. For example, an AM technique may be used to create an interlayer from any one of or any combination of aluminum (Al), cobalt (Co), chromium (Cr), copper (Cu), iron (Fe), molybdenum (Mo), niobium (Nb), tantalum (Ta), titanium (Ti), nickel (Ni), tungsten (W), yttrium (Y), zirconium (Zr) or their alloys, or steels.

Directed Energy Deposition (DED)

Directed energy deposition (DED) covers a range of terminology including direct metal deposition (DMD), laser engineered net shaping, directed light fabrication, blown powder AM, and 3D laser cladding. In these types of processes. focused thermal energy is used to fuse materials by melting the material as it is being deposited. In some embodiments, a laser is the source of energy and the material is a metal powder or wire.

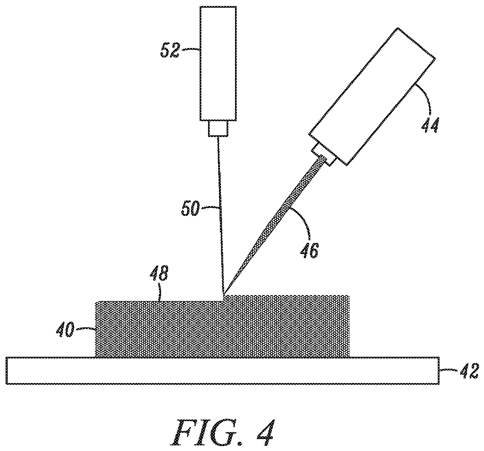

FIG. 4 illustrates a general schematic for directed energy deposition, which uses focused thermal energy to fuse materials by melting the material as it is being deposited. In this process, a build object 40 is created on a solid build platform 42. An arm 44 that is capable of rotating on multiple axes deposits material 46 in the form of a wire or powder. Material 46 is deposited onto existing or solidified surface 48 of the build object 40. After deposition, material 46 is melted using focused energy 50 such as a laser, electron beam or plasma arc, from an energy source 52. Material 46 then cools or solidifies and become the existing surface 48 for the next later of material 46. In this way, material 46 is added layer by layer and solidifies, creating or repairing new material features on the build object 40.

In this technique, a laser can be the source of energy 50 and the material 46 can be a metal powder. In some cases, metal powder is injected or deposited on a pool of molten metal created by the laser. Other names for this technique include blown powder AM and laser cladding. Some unique capabilities include simultaneous deposition of several materials, making functionally graded parts possible. Most directed energy deposition machines also have a 4- or 5- axis motion system or a robotic arm to position the deposition head, so the build sequence is not limited to successive horizontal layers on parallel planes. Hybrid systems can also combine powder-fed directed energy deposition with CNC milling (e.g. 4- or 5- axis milling).

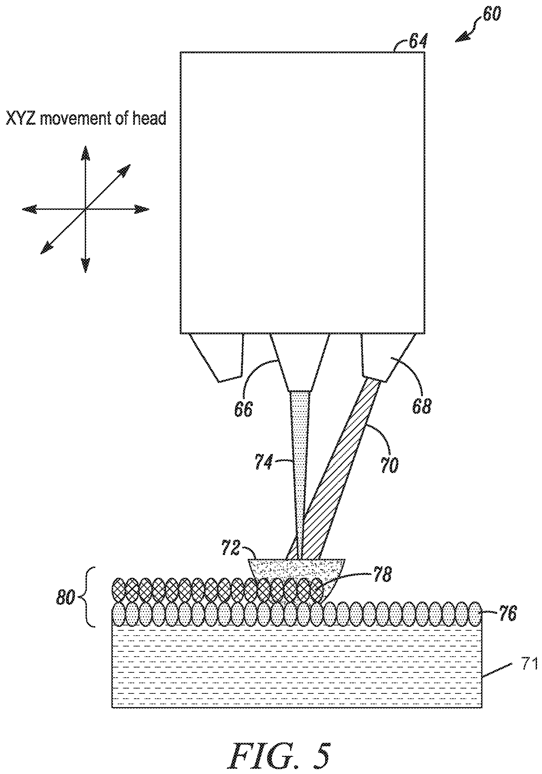

Illustrated in FIGS. 5-8 are various further descriptions of systems of directed energy deposition, such as DMD, methods according to the instant disclosure.

An exemplary schematic of a DMD system 60 is shown in FIG. 5. In some embodiments, the system 60 has a 4- or 5- axis computer numerical control (CNC) controlled motion system or a robotic arm to position a deposition head 64, so the build sequence is not limited to successive horizontal layers on parallel planes. The deposition head 64 contains an energetic and focused thermal source 66, such as a laser, e-beam or plasma welding torch, and at least a first feeder 68. In some embodiments, the first feeder 68 is configured to deliver a build material 70 such as a metal in the form of a powder. The metal powders are moved from on-board systems by an inert gas, in some embodiments at a pre-defined rate, to the first feeder 68 and deposited on a pool 72 of molten metal created by the traversing energy source 74. The molten pool 72 can include both molten incoming build material and a portion of the top of the previous layer of substrate. The pool 72 of molten material enables the binding and mixing of the powders coming from one or multiple feeders and as a result, a layer with a given composition is created. Due to a fast cooling rate, solidification is extremely rapid and occurs almost immediately behind the moving energy beam 74 where a solid layer is now present. In some embodiments, two layers, each with different compositions are deposited by changing the composition of the first feeder between each layer. For example, a first layer 76 having a first composition such as a high concentration of tungsten (W) or copper (Cu) is laid down on a substrate 71, such as build platform, a sputtering target, a backing plate or a previously deposited layer. Next, the composition of the material coming out of the first feeder 68 is changed and a second layer 78 having a different ratio of tungsten (W) to copper (Cu) than the first layer 76 is laid down. After this process has been repeated, an interlayer 80 having a gradient composition is formed.

In some embodiments, a first layer 76 having a first composition such as a first concentration of two or more materials is laid down. Next, the composition of the materials coming out of the first feeder 68 is changed and a second layer 78 having a different ratio of the same materials is laid down. After this process has been repeated a number of times, an interlayer 80 having a gradient is formed. It is also envisioned that individual layers may be formed, with each layer having different materials than the previous layer. For example, the composition of the first layer 76 may be chosen to create a layer having a particular CTE. First layer 76 may include a first material and a second material. Additionally, first layer 76 may include a third material or any number of additional materials to achieve the particular CTE. A subsequent layer may be formed having a different ratio of the same materials as present in the first layer 76, or possibly materials that are different from the first layer 76, so long as the CTE of the subsequent layer is higher than the first layer 76. In other words, each layer may have the same materials as the adjoining layer in a different ratio, or may have different materials, so long as the CTE of each layer forms a gradient in a direction from one side of the interlayer to the opposite side. In this manner, an entire interlayer may be formed, with each layer having a different material composition than the previous layer, so long as the CTE of each individual layer is higher or lower than the previously formed layer.

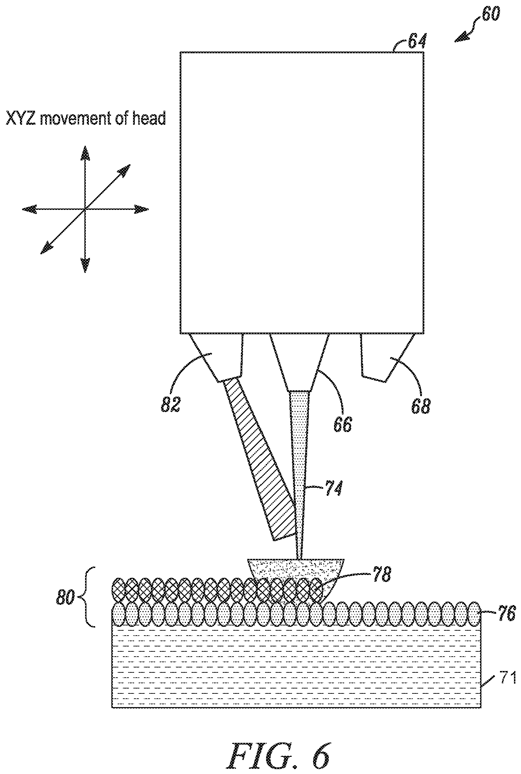

As shown in FIG. 6, it is possible to have a two feeder system to allow a user to change the material that is being prepared for the successive layer while a material layer is being laid. The system 60 is similar to that shown in FIG. 5 except the deposition head 64 has both a first feeder 68, which can deposit a first material 84, and second feeder 82, which can deposit a second material 86. Using both the first feeder 68 and the second feeder 82, layers with different compositions can be deposited faster by switching between feeders with a new composition for each layer. For example, a first layer 76 having a first composition, such as a first ratio of two or more components, is laid down with the first feeder 68. Next, a subsequent layer 78 having a second ratio of two or more components different than the ratio present in the first layer 76 is laid down by the second feeder 82. While the second feeder 82 is laying material, the composition of the material to come out of the first feeder 68 is changed. In this manner an interlayer 80 having a gradient material is produced.

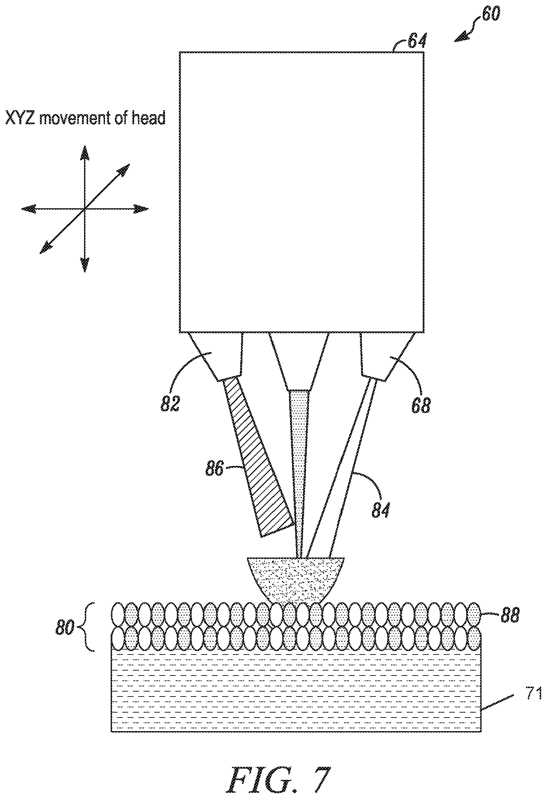

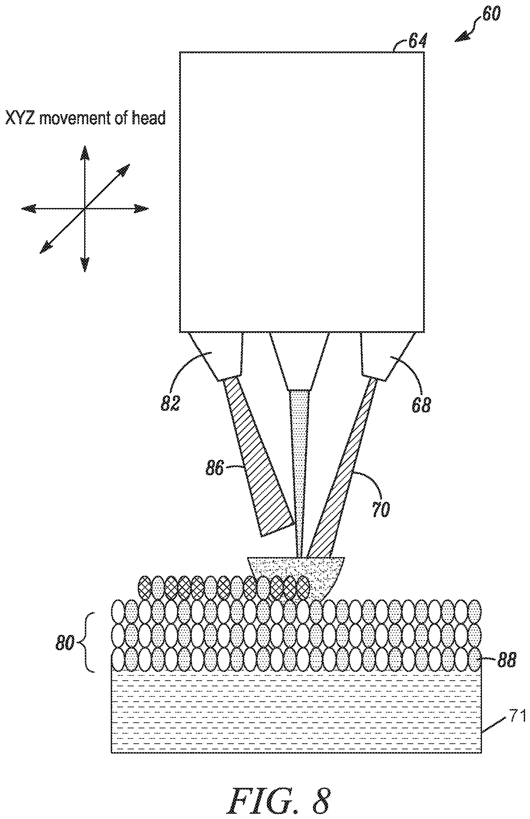

As shown in FIGS. 7 and 8, it is possible to tailor the composition of each layer during the deposition by varying the respective amounts of powder coming from two or more feeders by precise control of the ejection rate of each feeder. The final result is a 3D deposition of a complex material with multiple layers or different and potentially new composition that is identical in shape and geometry to that of the input computer aided design (CAD) model.

As shown in FIGS. 7 and 8, in some embodiments, the system 60 may include a deposition head 64 having at least two feeders. As shown in FIG. 7, the first feeder 68 can be used to deposit a first material 84 having a particular material composition, such as one with a first ratio of two or more components. The second feeder 82 can be used to deposit a second material 86 having a material composition having a ratio of two or more components different than the first material 84. Each feeder can be laying material at the same time onto the previously formed layer. The ratio of each element or alloy in the material can be controlled during the deposition process, thus the composition of each layer can be tailored as the deposition process is taking place. For example, the first material 84 being deposited by the first feeder 68 may be all copper (Cu), while the second material 86 may be all tungsten (W). Alternatively, the first material 84 being deposited by the first feeder 68 may be a combination of copper (Cu) and tungsten (W) while the second material 86 may be a combination of aluminum (Al) and tungsten (W). In some embodiments, the first material 84 and the second material 86 may contain three components in various combinations. By controlling the amount of material being deposited from each feeder, the material composition of each layer can be controlled as the material is being laid. The result is an interlayer 88, as shown in FIG. 8, having a material gradient 80 that can be altered even as each layer is formed.

In some embodiments, the feedstock may comprise wire instead of powders. In this example, the thermal source melts and atomizes the wires into fine powders before they get trapped and mixed into the molten pool.

In some embodiments, the DMD system has hermetically sealed chambers purged with argon or with a high vacuum in order to keep oxygen and moisture levels can be below 10 ppm. Such an environment helps prevent oxidation and contamination and keeps parts clean in order to ensure the best quality material. Powder feeding systems and ejected powders are also surrounded by a gas shield, such as argon, to provide additional protection as well as pressure.

Sheet Lamination

Sheet lamination is another 3D printing technique that can produce parallel stacks of thin layers of different materials. Sheet lamination is an AM process where sheets of material are bonded to form a 3D object. Sheet lamination can be used to produce stacks of thin foils with different CTEs on top of either the backing plate or target material.

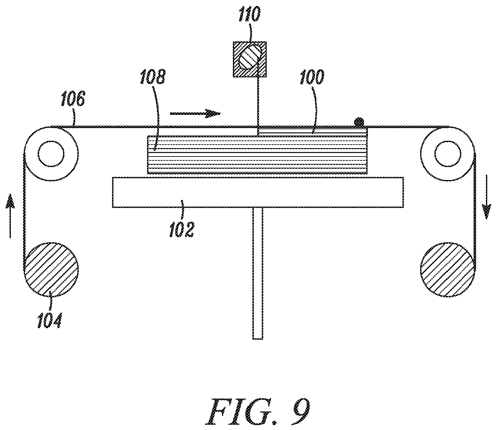

As shown in FIG. 9, preformed material sheets 100 of build material having components in predetermined ratios are positioned in place on a cutting bed 102 by rollers 104 and optionally additional devices for providing the material sheets 100 such as a belt 106. The material sheets 100 are bonded in place, in a specific sequence over the previously bonded layers 108, using an adhesive or energy source. The required shape is then cut from the bonded material sheet 100, by a cutting tool 110 such as a laser or knife. The cutting or bonding steps can be reversed and alternatively, the material sheets 100 can be cut before being positioned and bonded. For metals, sheet materials are often provided in the form of metal tapes or foils. In particular, in ultrasonic additive manufacturing (UAM), metal foils and tapes can also be welded together by a combination of ultrasonic energy supplied by twin high frequency transducers and the compressive force created by the system's rolling sonotrobe. Sheet lamination technology can be combined with full CNC-machining capabilities.

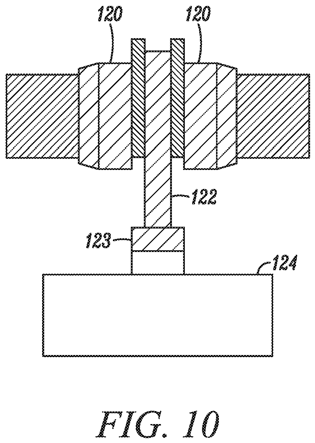

In some embodiments, one type of sheet lamination technique that is particularly well suited for metals and alloys is ultrasonic additive manufacturing (UAM). As shown in FIG. 10, UAM uses a rolling ultrasonic welding system that includes two ultrasonic transducers 120 and a welding horn 122. The foils 123 of material can be placed between the welding horn 122 and a substrate 124, for example another foil of material. High frequency (such as 20,000 hertz) ultrasonic vibrations are transmitted to the disc shaped welding horn 122 that are in turn applied to the foils 123 held together under high pressure to create a weld. This method provides low temperature welding driven by friction and pressure due to ultrasonic motion. In a first phase the repetitive ultrasonic shearing motion breaks any surface oxide and flattens any surface asperity. In the subsequent process, microasperities are collapsed by the ultrasonic motion. As a result, the heat and pressure from the horn leads to the formation of a solid state bond.

UAM usually combines a rolling ultrasonic welding system with CNC milling capabilities to ensure good tolerance or shape and ensure that the 3D shape and geometry follows the input CAD design. For example holes or changes in the surfaces can be milled if needed. UAM can be a very efficient technique to build multiple stacks of readily available foils of material, such as foils having titanium (Ti), aluminum (Al), or copper (Cu) in various ratios, on top of backing plate material. The low temperatures involved reduce the thermal stresses during manufacture. Also, because UAM utilizes solid foils instead of powders, it eliminates sources of porosities within each layer.

Other AM techniques that can be used to build 3D structures made of metals and alloys include binder jetting, powder bed fusion, cold spray, thermal spray, and plasma spray.

Binder Jetting

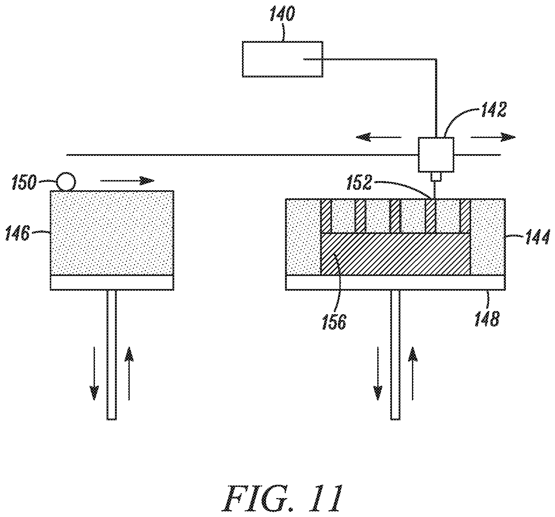

Binder jetting, as shown in FIG. 11, involves a liquid bonding agent selectively dispensed through a liquid adhesive supply 140 deposited through inkjet print head 142 nozzles to join powder materials in a powder bed 144. With binder jetting, the dispensed material is not build material, but rather a liquid that is deposited onto a powder bed 144 to hold the powder in the desired shape. Powder material is moved from a powder supply 146 and spread over the build platform 148 using a roller 150. The print head 142 deposits binder adhesive 152 on top of the powder bed 144 where required. The build platform 148 is lowered as the build object 156 is built. Once the previously deposited layer has been bonded, another layer of powder is spread by the roller 150 over the build object 156 from the powder supply 146. The build object 156 is formed where the powder is bound to the binder adhesive 152. Unbound powder remains in the powder bed 144 surrounding the build object 156. The process is repeated until the entire build object 156 has been made.

Metals parts produced by binder jetting usually must be sintered and infiltrated with a second metal after the AM build process. An example is the use of bronze infiltrant for stainless steel, bronze, or iron parts. Other infiltrants can be aluminum (Al), glass or carbon fibers. During a post-build furnace cycle, the binder is burned out and bronze is infiltrated into the parts to produce metal alloys. This technique can be used to produce a graded composition. However, besides the use of powder bed, this technique has other potential disadvantages for producing graded compositions: i) additional cost of sintering and infiltration steps, ii) more risk for unwanted porosities during infiltration step and iii) limitation in the number of infiltrant materials and therefore achievable compositions.

Powder Bed Fusion

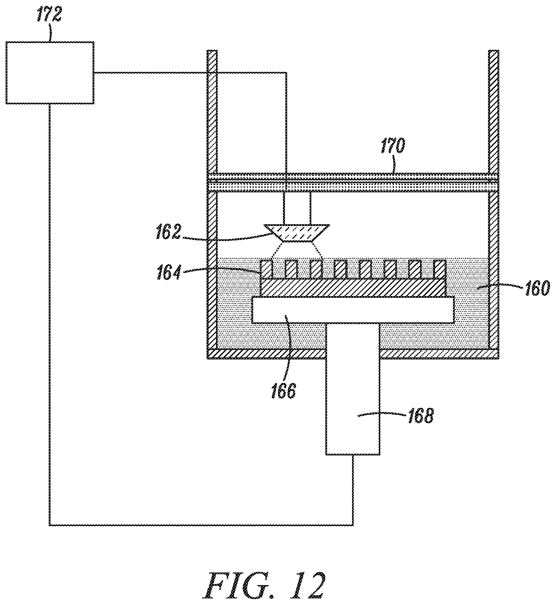

Powder bed fusion is an AM method in which thermal energy, such as a laser, selectively fuses regions of a powder bed, such as that shown in FIG. 12. An AM device may include a bed of build material 160, such as metal or metal alloy powder. The build material 160 may also be deposited layer by layer at the top of a build platform 166 for retaining a three dimensional structure 164 to be built. Build material 160 may be added layer by layer on top of each other and solidified to progressively form the three dimensional structure 164. The build platform 166 is often attached to an elevator 168 that moves up or down relative to the build material 160 to assist in adding additional layers of build material 160. A melting or curing apparatus 162 is generally positioned above the build platform 166. The curing apparatus 162 may include a device for melting build material 160 such as metal, or may include a curing device for curing laminate or other material. The melting or curing apparatus 162 is often connected to a raster 1 70 that moves the melting or curing apparatus 162 in relation to the build platform 166 in order to melt various locations of the material being built. In some embodiments, an AM apparatus does not have a material bed 160, but instead the melting apparatus 162 includes a dispenser that melts and dispenses material onto the build platform 166 and adds subsequent layers of material to build the three dimensional structure 164. The elevator 168 and melting and curing apparatus 162 are controlled by a control system 172 that governs how the three dimensional structure 164 is built based on the movement of the elevator 168 and melting and curing apparatus 162.

The thermal energy melts a selected portion of a layer of powder material, which then changes to a solid phase as it cools. For metal parts, anchors may attach the parts to a base plate and support down facing structures. This is necessary due to the high melting point of metal powders that can create a high thermal gradient resulting in thermal stresses and warping if anchors are not used. Other common names for powder bed fusion include laser melting (LM), selective laser melting/sintering (SLM/SLS), direct metal laser sintering (DMLS) and electron beam melting. In some embodiments, the target material or backing plate may be inserted in the powder bed and used as a substrate above which various layers are deposited and then selectively annealed by laser to create a gradient in grain size as described in above paragraph.

Cold Spray

Cold spray involves propelling build material against a substrate with enough kinetic energy to produce a dense coating or freeform. Cold spraying does not result in melting the build material and thus can be performed at relatively low temperatures The process can be carried out by spraying solid particles at high velocities (such as between about 500 m/s and 1500 m/s) to form deposits by plastic deformation. Cold spray techniques can be used to avoid metal oxidation and form high density hard metal deposits.

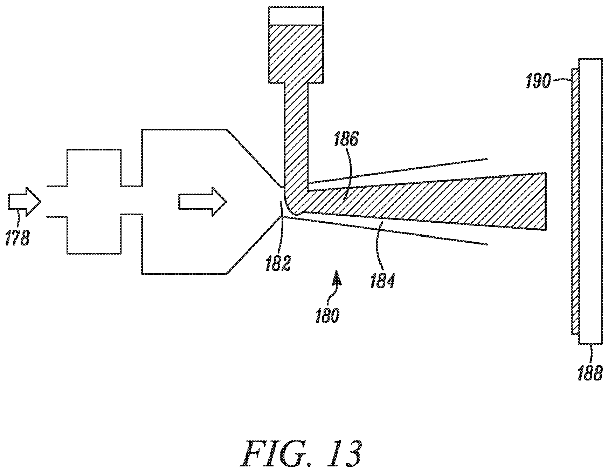

As shown in FIG. 13, in some embodiments, the method includes propelling a heated pressurized carrier gas 178 through a de Laval or convergent-divergent 180 nozzle. If a gas is flowing at subsonic speeds, the gas is compressible and sound will propagate through it. In a de Laval nozzle, at the convergent section 182 of the nozzle where the cross-section of the nozzle decreases, a choke forms. Because the gas flow is isentropic, the gas velocity will become sonic where the cross-section is at a minimum. As the gas enters the divergent section 184 of the nozzle, the gas expands and reaches supersonic speeds. The build material 186 is injected into the gas stream either upstream or downstream from the choke point. The carrier gas 178 carries the build material 186 out of the nozzle 180. The exit speed of the build material 186 from the nozzle 180 must be high enough to cause it to plastically deform upon impact with a substrate 188 to form a well bonded coating 190 and dense build layer. Using this form of nozzle, supersonic exit velocities are thus possible and thus the build material 186 reaches the necessary particle velocity required to produce bonding. It is currently possible to create build objects from certain metals, including titanium (Ti), cobalt (Co), chromium (Cr), and alloys such as titanium-aluminum-vanadium (TiAIV) alloys, and nickel (Ni)-based alloys using cold spray additive manufacturing.

Thermal Spray

Thermal spray methods, such as plasma spray, high velocity oxygen fuel (HVOF) spray, arc spray, and flame spray generally involve melting a build material into droplets with a heat source and spraying the melted build material onto the substrate or build surface at high velocity. Build material can be melted with various energy sources such as chemical combustion, plasma, or electric arc. A metallic build material can be provided as a feedstock as a powder or wire or metal matrix composites.

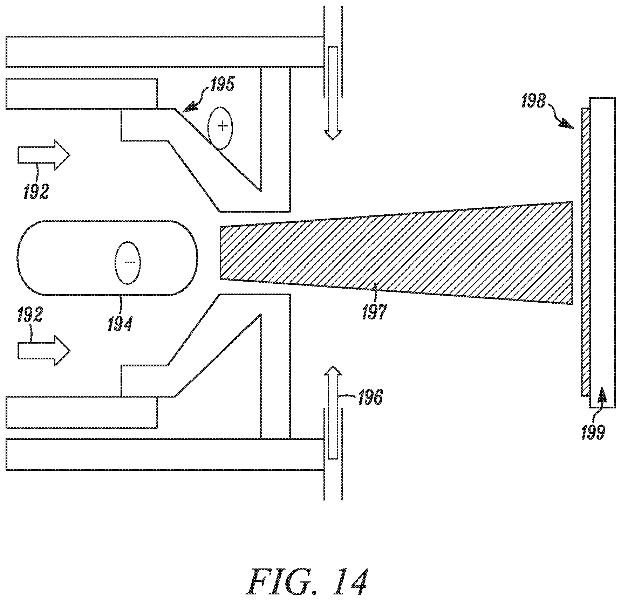

As shown in FIG. 14, in some embodiments, plasma spray equipment can include a plasma gas 192 accelerated by a combination of a cathode 194 and anode 195 in line along the flow path. The build material 196 is introduced into the stream of plasma gas 192 which carries the build material 196 out of the nozzle as a particle stream 197. The build layer 198 consists of a multitude of pancake-like deposits of build material called lamellae, formed by flattening of the liquid droplets on the substrate 199.

AM Method of Forming Interlayer

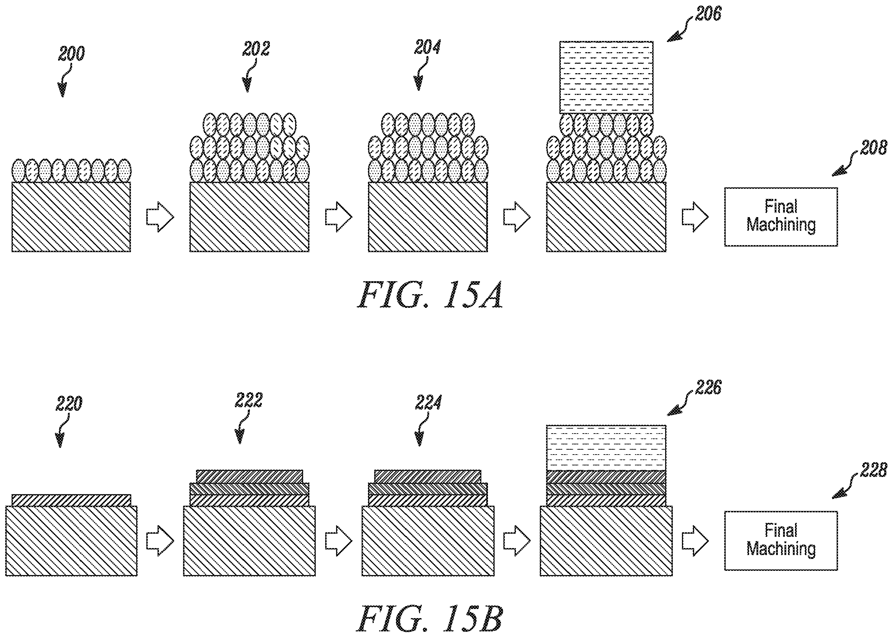

FIGS. 15A and 15B describe processing steps that may be used in conjunction with an AM method, according to some embodiments.

In some embodiments, exemplary forms of AM that may be used to produce an interlayer having a gradient in grain size and texture between a backing plate and a sputtering target include DMD and DED (FIG. 15A) and sheet lamination (FIG. 15B). As shown in FIG. 15A, a DMD process begins in step 200 by depositing layers of powdered metal of a first composition onto a backing plate and using thermal energy to fuse and mix the powder and create the first layer composition. In step 202, subsequent layers of material are laid, each having a progressively higher concentration of a first material and a corresponding progressively lower concentration of a second material than the previously laid layer. In steps 202, the gradient in grain size is controlled by the power of thermal energy source, scanning speed, cooling rate, initial powder size and post-thermal processing. When creating the interlayer, the composition of the powder of the final layer is generally the same or similar to that of the sputtering target material.

Once the entire interlayer is formed, it may be surface treated in step 204 using CNCI, milling per CAD design for preparing the surface of the interlayer before the next step. In step 206, the sputtering target is added to the interlayer. This can be carried out using any bonding step that is suitable and that may help heal any defects in the interlayer. In some embodiments, a diffusion bonding method such as hot isostatic pressing "HIPping" may be used. Finally in step 208, the target assembly having the backing plate, interlayer, and sputtering target joined may undergo a final machining step to smooth the surfaces for example.

FIG. 15 B illustrates an exemplary process utilizing sheet lamination, such as ultrasonic additive manufacturing. In the sheet lamination method shown in FIG. 15B, each sheet of material has a particular, predetermined composition that may have a desired relative content ratio of two metals or metal alloys. Thus the sheets must be placed and joined in a controlled order. In step 220, a first sheet of material having a metal concentration similar to that of the backing plate is laid over and joined to the backing plate. In step 222, subsequent sheet of material having metal concentrations that gradually change from a high concentration of a first metal to a high concentration of a second metal are added in sequence and joined together. In step 224, the interlayer may be subjected to a CNC lathe or other method for treating the surface of the interlayer, and get it ready for a bonding step. The bonding step 226 may be any suitable method for joining the sputtering target to the interlayer and backing plate. In some embodiments, a diffusion bonding method such as hipping may be used. Finally in step 228, the target assembly having the backing plate, interlayer, and sputtering target joined may undergo a final machining step to smooth the surfaces for example.

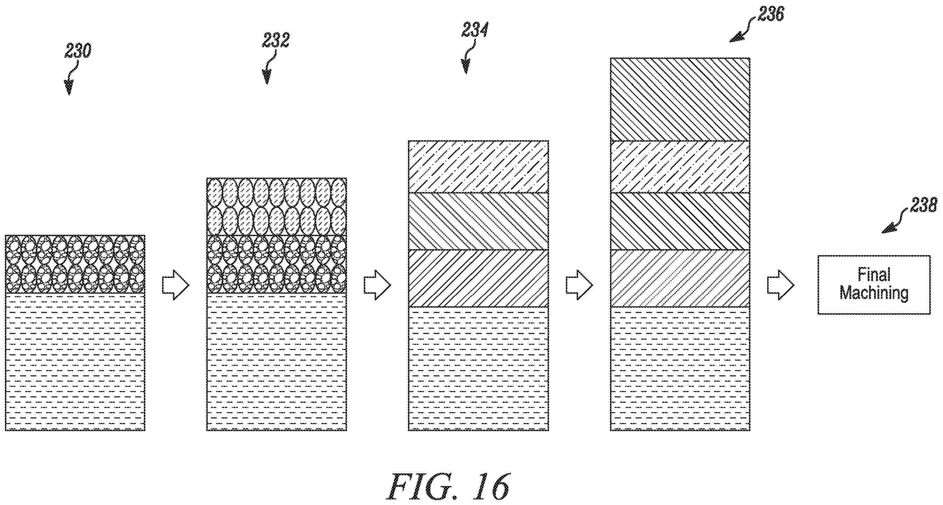

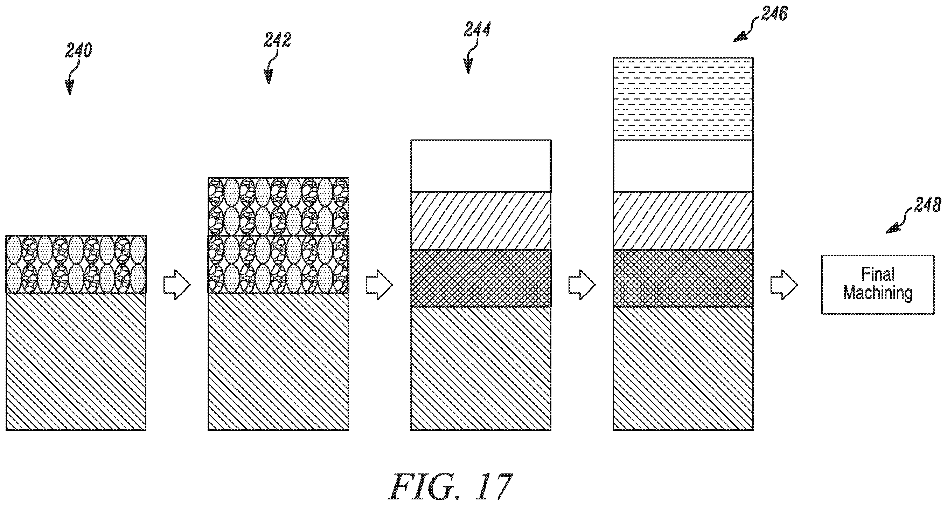

As shown in FIGS. 16 and 17, in some embodiments the AM process may be carried out directly on either the sputtering target (FIG. 16) or directly on the backing plate (FIG. 17). In some embodiments, the interlayer may be formed with AM completely separate from the backing plate and the sputtering target and may be subsequently positioned between and bonding to the backing plate and the sputtering target. FIGS. 16 and 17 also illustrate the method of controlling other properties of each layer in addition to the composition, properties such as grain size of microstructure and texture.

As shown in FIG. 16, in step 230_ a powdered layer is laid onto the target and thermal energy is used to fuse the powder. This same step can be carried out directly on the target as shown in FIG. 16, or directly on the backing plate as shown in FIG. 17, step 240. The thermal energy can be controlled to tailor the grains to a suitable size. AM processes melt a very small amount of material at a time. As a consequence very rapid solidification, much faster than in traditional processes, takes place, resulting in a more uniform and finer microstructure throughout the part compared to traditional processes, such as casting or powder metallurgy. Also, for alloys, segregation of alloying elements happens on a much smaller scale. This means that generally AM layers deposited on target material will have a smaller and more uniform grain size than the target material.

Next in step 232 of FIG. 16 and step 242 of FIG. 17 additional layers of powder are added and fused. Each layer of material may have a different concentration of material as the previous layer, and may also have a different grain size as the previous layer. Moreover the grain size of each layer may be controlled by controlling the energy source, as described below.

Additional control of grain size is possible within the deposited layers during the AM process. In steps 234 of FIG. 16 and 244 of FIG. 17 the amount of thermal energy used may be controlled, for example the power may be changed and the scanning speed may vary. One option is to perform intermediate local heat treatment during AM steps by using the laser or e-beam source. This can be done once a few layers have been deposited and have already solidified. The power and scanning pattern of the laser or e-beam source is then lowered to generate enough heat to grow the grain size of deposited layers to a specific value without inducing any melting. This method can create several regions each containing several deposited layers with a given grain size. Another option is to choose powders of various sizes for the AM deposition processes. As a general rule finer powders can give finer final grain size as long as melting conditions are optimized. Finer powders are usually more expensive and costs are usually greater for bulk pieces of material. However, costs can be acceptable when a relatively much smaller volume of deposit is used on one side of the target. Another option is to perform the heat treatment as a whole over the entire layer once all the layers are deposited either by using the laser source or by heating in situ the entire chamber in a conventional oven. In that case, grain size growth is not as localized as in the previously described option but happens more uniformly across the whole deposit.

In steps 236 of FIG. 16 and 246 of FIG. 17, similar methods as described in previous options are used and include preparations for bonding, bonding preferably by hipping, final machining and packaging. Grain sizes may be less thermally stable than composition and density and therefore any grain size gradient may be more sensitive to heat and temperature. In the case of sputtering targets, this means in practice that the temperature of bonding (usually 300°C-500°C) should be much less than the temperature of grain growth of the material, which usually occurs at 0.4-0.5Tm where Tm is the melting point of a given material. For example, the melting point of tungsten (W) is 3410°C, which means 0.4Tm is about 1360°C and therefore grain growth will not occur in a graded multilayer containing tungsten (W) if the bonding step is carried out from 170°C to 500°C.

One additional advantage of AM is that the bonding surfaces can be more precisely prepared and controlled to create an improved or superior bond strength. For example, features such as dents, steps, grooves, or keys can be printed at the surface of the interlayer in order to improve the bond strength between the interlayer and the sputtering target or backing plate. Those features can be made more refined and complex by AM techniques. Near net shape fabrication reduces fabrication time and material costs. In addition, AM techniques including DED, DMD, and UAM may be combined with CNC milling capabilities. In some embodiments CNC milling can be used in combination with AM to provide a superior or improved surface finish and dimensional tolerance, for example, CNC milling can be used to machine grooves on the top surface of the graded interlayer to facilitate the bonding step. For example, CNC milling may be used to create a surface consisting of triangular dents across a face of the interlayer.

Solid state bonding of the target to the gradient interlayer and the backing plate assembly is performed next. In some embodiments, HIPping is preferred because it exerts an isotropic pressure from all directions on a part at a relatively high temperature. This method helps promote diffusion and reduced porosity while at the same time provides a solid state diffusion bond. Heat treatment performed before, during, and especially after HIPping also helps reduce residual stresses. Additionally, heat treatment during bonding steps can sometimes help promote further inter-diffusion between the AM formed layers and in effect produces a more continuous gradient in composition that further helps reduce thermal stresses.

Finally, in steps 238 of FIG. 16 and 248 of FIG. 17 a final machining step may be used to polish the surface of the sputtering target and/or the backing plate. A cleaning step may also be used to remove any residual material that may remain after the AM process.

As described above, AM techniques that use a thermal source such as a laser or electron beam can form layers of material with a gradient material composition and a controllable grain size on one surface of either the target or the backing plate. For example, for a tungsten (W) target with a copper (Cu) alloy backing plate, it can be advantageous for example to form a near net shape W/Ti/Cu or W/Mo/Cu layer stack. A general three layer stack will be of the form W/X/Cu where X is a metal or alloy having a CTE coefficient between the target material (tungsten (W) in this example) and the backing plate material (copper (Cu) alloy in this example).

The method can be extended further to the case of a four layer stack of the form W/X/Y/Cu where X and Y are metals or alloys having a CTE coefficient between the target material (tungsten (W) in this example) and the backing plate material (copper (Cu) alloy in this example). In another example, the CTE of Y is closer to the backing plate material (copper (Cu) alloy in this case) compared to that of the X because Y is deposited directly on the copper (Cu) alloy backing plate. In sum: the CTE of W < CTE of X < CTE of Y < CTE of Cu.

This procedure can be generalized to multiple stacks of multiple materials forming a gradient in CTE by controlling the composition and/or density of each layer. One method for creating material having a gradient composition would be a method that is controllable and involves a single continuous step for best efficiency and cost reduction. In some embodiments, a user can also tailor a gradient composition at an atomic or micro-scale and provide an almost continuous variation in composition and properties through the material thickness. Having a method that can control a gradient in grain size and texture will also lead to better control over local stresses and reduce cracking that occurs near the bond line, especially for brittle target materials.

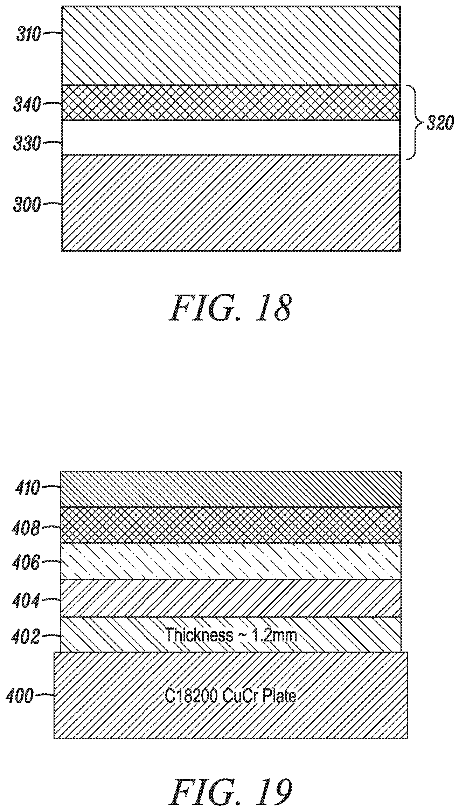

In some embodiments, an interlayer 320 may be tailored to have a specific CTE at specific locations of the interlayer 320. As shown in FIG. 18, a sputtering target 300 and a backing plate 310 may have different or dis-similar CTEs. To provide a suitable interlayer 320 a first layer or portion 330 of the interlayer can be formed with a first ratio of two or more components. For example, the first layer 330 may have a first ratio having a high concentration of component A and a low concentration of component B. Optionally, additional components, such as component C, component D and more, can be included in first layer 330. A second layer or portion 340 of the interlayer 320 adjacent first layer 330 may have a lower concentration of component A and a higher concentration of component B. Optionally additional components such as component C, component D and more, can be included in second layer 340. The additional components may be present at a higher concentration in the second layer 340 than in the first layer 330. In some embodiments, multiple layers can be formed above the second layer 340 and each layer can have a progressively lower concentration of component A, and a progressively higher concentration of component B. In some embodiments, components C, D and/or more can also progressively increase. Alternatively, the concentration of one or more of the additional components may be held constant, while only the concentrations of component A and component B change with each subsequent layer that is added. This process is repeated (i.e., a plurality of layers can be formed) until the final layer adjacent the backing plate 310 is formed having a low concentration of component A, a high concentration of component B, and optionally a higher concentration of component C and/or D. The completely formed interlayer 320 thus has a specific CTE in each layer from a first side of the interlayer adjacent the sputtering target 300 to a second side adjacent the backing plate 310. In some embodiments, the CTE of each layer can be different than that of an adjacent layer. In other embodiments, the CTE of some but not all of the layers can be different.

Referring again to FIG. 18, in some embodiments, the interlayer 320 may be formed from layers having two or more components where the components vary layer to layer. For example, the first layer 330 may be formed from component A, component B, and component C. Each component and the ratio of each component within each layer are chosen to produce a layer having a particular material property such as grain size or CTE. The second layer 340 may be formed from components, A, B and C, and additionally or alternatively component D, component E, and component F. Additional layers may be added to build a complete interlayer, with each subsequent layer will having particular combinations of the various components chosen to create a layer having for example a higher or lower CTE than the previously formed layer. The completely formed interlayer thus has a material property gradient, such as a CTE gradient; from a first side of the interlayer adjacent the sputtering target 300 to a second side adjacent the backing plate 310.

EXAMPLES

The following non-limiting Examples illustrate various features and characteristics of the present invention, which is not to be construed as limited thereto and wherein all percentages are weight percentages unless otherwise indicated.

Example 1: Use of AM to form a gradient interlayer of copper (Cu) and titanium (Ti) for binding a tungsten (W) target to copper-chromium (CuCr) backing plate:

FIGS. 19-22 illustrate an example of the use of a directed energy deposition technique, in this case direct metal deposition (DMD), to create a gradient in composition. The sputtering target was a 15 cm (6 inch) diameter and 1 cm (0.5 inch) thick W target. The backing plate was a 15 cm (6 inch) diameter and 2 cm (0.75 inch) thick CuCr C18200 backing plate. An about 6 mm thick functional gradient interlayer was created by a stack of five 1.2 mm thick layers with different copper (Cu)/titanium (Ti) compositions. Titanium (Ti) was chosen to be mixed with copper (Cu), the primary element of backing plate, because titanium (Ti) has a CTE of $8.6 \times 10^{-6}$ m/(m K), which is between that of copper (Cu) and tungsten (W).

The compositions for the interlayer layers were mechanically mixed prior to DMD and put in separate powder feeders of the DMD system. The method used here is similar to that described above for FIG. 6. DMD was used with one powder feeder to deposit the first 1.2 mm thick layer containing the first composition, and then switched to a different powder feeder containing the second composition to build another 1.2 mm thick layer and so on for the remaining layers. The layer with the highest copper (Cu) content (95%Cu + 5%Ti; layer 402) was deposited first on the Cu alloy backing plate 400 made of CuCr (C18200 backing plate with composition of 1.6 wt% chromium and remainder copper (Cu1.6°%Cr ) and CTE = 17.6 $\times 10^{-6}$ m/(m K)). For the next 4 layers (layers 404-410), the composition was varied such that the amount of copper (Cu) (from 75% to 50% to 25% to 15%) was gradually diminished and that of titanium (Ti) was increased in proportion (from 25% to 50% to 75% to 85%). As a consequence, the CTE was decreased gradually from the first layer adjacent to CuCr to the fifth one (to contact W) thereby minimizing gradually CTE mismatches. The arrangement of these layers and compositions are illustrated in FIG. 19 and summarized in Table 1.

| Table 1 | | | |
|---|---|---|---|
| | Ti wt % | Cu wt % | Temperature |
| Layer 402 | 5 | 95 | 590C |
| Layer 404 | 25 | 75 | 460C |
| Layer 406 | 50 | 50 | 350C |
| Layer 408 | 75 | 25 | 250C |
| Layer 410 | 85 | 15 | 250C |

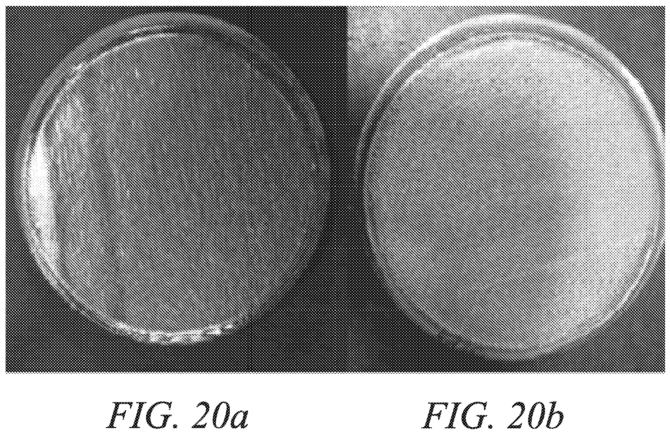

To facilitate adhesion and reduce porosities, each deposited layer was preheated before each laser application. This treatment allows also for some limited diffusion and homogenization of composition. Preheat step temperature was decreased slowly for each successive layer to minimize stresses and take into account compositional changes. Note that the total DMD cycle was relatively short for a total of 185 minutes and is therefore amenable to production applications. FIGS. 20a and 20b are photographs of the interlayer following deposition of two different layers. Specifically, FIG. 20a is an image of the interlayer after deposition of layer 408 (25wt% copper (Cu) and 75 wt% titanium (Ti)), and FIG. 20b is an image of the interlayer after deposition of layer 410 (15wt% copper (Cu) and 85wt% titanium (Ti)).

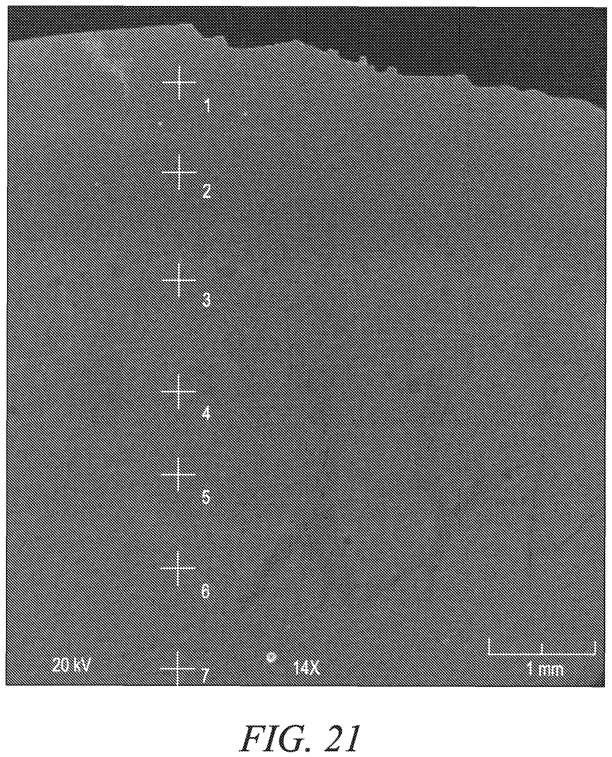

Observation of a cross section of the interlayer by SEM/EDX is shown in FIG. 21, and indicates that the actual compositions of the deposited layers were relatively close to the original powder mixture. Samples were taken at seven locations in a line through the interlayer in a direction perpendicular to the build surface. Table 2 contains the weight percent concentration of Ti and Cu at each location.

| Table 2: Gradient Interlayer Concentrations | | |
|---|---|---|
| Location | Ti wt % | Cu wt % |
| 1 | 88.49 | 11.51 |
| 2 | 87.85 | 12.15 |
| 3 | 47.43 | 52.57 |
| 4 | 30.60 | 69.40 |
| 5 | 16.92 | 83.08 |
| 6 | 12.79 | 87.21 |
| 7 | 4.15 | 95.85 |

With reference to Table 2 above and the corresponding location numbers in FIG. 21, the above example illustrates an interlayer where locations 1 and 2 are a layer having a composition having greater than an 85% Ti and less than 15% Cu mixture. Location 3 is a layer having approximately a 50%Ti with 50% Cu mixture. Location 4 is a layer having roughly a 30% Ti and 70% Cu mixture. Locations 5 and 6 have approximately a 15% Ti with 85% Cu mixture. And location 7 is a layer having from a 5% Ti with 95% Cu mixture.

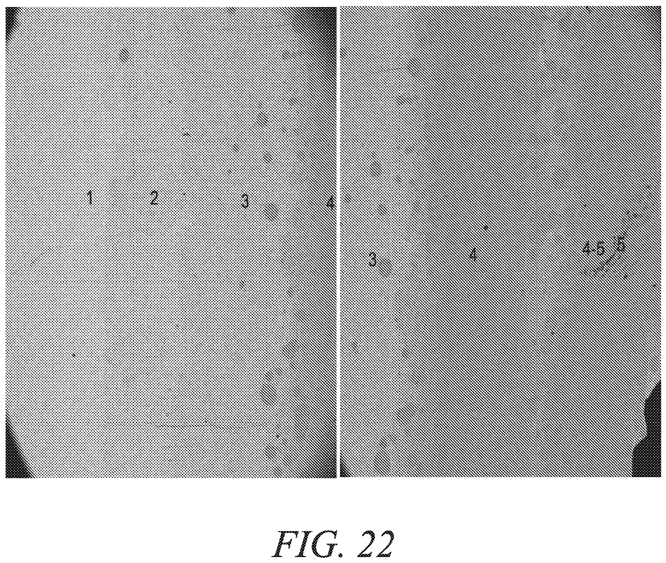

As also seen another view shown in FIG. 22, no cracks were observed at the interfaces between the layers, indicating an acceptable and excellent bond and a consistent deposition. A minimum and acceptable amount of porosity was seen. A combination of factors may have contributed to this: i) the small volume where melting and solidification takes place, ii) the pressure of shield gas that surrounds the powders and molten pool, and iii) the pre-heat treatment steps. It was also observed that the bonding step, especially when done by hipping contributes further to a reduction in the porosity.

Disclosed herein is a sputtering target assembly comprising a sputtering target having a rear surface; a backing plate having a front surface; and an interlayer disposed between the target and the backing plate. The interlayer comprises at least a first material and a second material, a first interlayer portion disposed proximate the target material rear surface, and a second interlayer portion disposed proximate the backing plate front surface. The first interlayer portion has a higher concentration of the first material than the second material, and the second interlayer portion has a higher concentration of the second material than the first material.

Also disclosed herein is a method of forming a sputtering target assembly, the method comprising forming an interlayer having at least a first material and a second material. The interlayer having a first interlayer portion and a second interlayer portion, wherein the first interlayer portion has a higher concentration of the first material than the second interlayer portion, and the second interlayer portion has a higher concentration of the second material than the first interlayer portion. The method includes arranging a target having a rear surface with the target rear surface adjacent to the first interlayer portion; arranging a backing plate having a front surface with the backing plate front surface adjacent to the second interlayer portion; and joining the target, the interlayer, and the backing plate together in a target assembly bonding step. Forming the interlayer includes forming the first interlayer portion having a first concentration of the first material; adding subsequent layers of material to the first interlayer portion wherein each layer of material has a lower concentration of the first material than the previously added layer; forming the second interlayer portion having a second concentration of the first material; and subjecting the interlayer to an interlayer bonding step.

Also disclosed herein is a method of forming a sputtering target assembly, comprising forming an interlayer having a first interlayer portion and a second interlayer portion wherein forming the interlayer includes forming the first interlayer portion, and adding build material layer by layer. The method also includes forming the second interlayer portion, and subjecting the interlayer to a bonding step. Along a direction from the first interlayer portion to the second interlayer portion, each layer of build material has a lower concentration of a first material and a higher concentration of a second material than the previous layer. The method also includes placing the interlayer between a sputtering target and a backing plate; and heating the sputtering target, the interlayer, and the backing plate to a temperature high enough to form a diffusion bond between the interlayer and the sputtering target and between the interlayer and the backing plate.

Also disclosed herein is a method of forming a sputtering target assembly, comprising forming an interlayer having a first interlayer portion and a second interlayer portion. Forming the interlayer includes forming the first interlayer portion having a first material property value, adding subsequent layers of material to the first interlayer portion, forming the second interlayer portion having a second material property value Along a direction from the first interlayer portion to the second interlayer portion, the interlayer has a material property value gradient from the first material property value to the second material property value. The method also includes subjecting the interlayer to an interlayer bonding step; arranging a sputtering target having a rear surface with the target rear surface adjacent to the first interlayer portion; arranging a backing plate having a front surface with the backing plate front surface adjacent to the second interlayer portion; and joining the sputtering target, the interlayer, and the backing plate together in a target assembly bonding step.

Various modifications and additions can be made to the exemplary embodiments discussed without departing from the scope of the present invention. For example, while the embodiments described above refer to particular features, the scope of this invention also includes embodiments having different combinations of features and embodiments that do not include all of the above described features.

## Claims

1. A sputtering target assembly comprising:

   a sputtering target (300) formed from a sputtering target material and having a rear surface;
   a backing plate (310) having a front surface; and
   an interlayer (320) extending between the target (300) and the backing plate (310), the interlayer (320) comprising a first layer (330) in direct contact with the sputtering target rear surface, and a second layer (340) in direct contact with the backing plate front surface;
   wherein the first layer (330) is formed of a first mixture containing a first material and a second material and having a higher concentration of the first material than the second material, and wherein the second layer (340) is formed of a second mixture containing the first material and the second material and having a higher concentration of the second material than the first material;
   wherein the first material and the second material are each present throughout the interlayer (320).

2. The sputtering target assembly of claim 1, wherein the interlayer (320) has a functional material gradient in any one of grain size, grain texture, material composition, or material component density along an axis extending through the sputtering target (300) and the backing plate (310), the axis perpendicular to the rear surface of the sputtering target (300).

3. The sputtering target assembly of claim 1, wherein the first layer (330) and the second layer (340) are each from about 0.5 millimeter to about 3 millimeters.

4. The sputtering target assembly of claim 1, wherein the coefficient of thermal expansion of the first layer (330) is within five hundred percent of the coefficient of thermal expansion of the sputtering target material.

5. The sputtering target assembly of claim 1, wherein the interlayer (320) further includes a third material.

6. The sputtering target assembly of claim 1, wherein the interlayer (320) further comprises a third material and wherein the first layer (330) has a higher concentration of the third material than the second layer (340).

7. A method of forming a sputtering target assembly, the method comprising:

forming a first layer (330) on a surface of a sputtering target (300) formed from a sputtering target material or a surface of a backing target (310) from a first mixture containing a first material and a second material; forming a second layer (340) on the first layer (330) from a second mixture containing the first material and the second material, wherein the first layer (330) has a higher concentration of the first material than the second layer (340), and the second layer (340) has a higher concentration of the second material than the first layer (330); arranging the backing plate (310) or sputtering target (300) on the second layer (340) to form an assembly having the first layer (330) and second layer (40) between the sputtering target (300) and backing plate (310); and joining the sputtering target (300), the first layer (330), the second layer (340), and the backing plate (310) together in a target assembly bonding step.

8. The method of claim 7, wherein the first layer (330) having at least a first material and a second material is formed on the surface of the backing plate (310), and the sputtering target (300) is arranged on the surface of the second layer (340).

9. The method of claim 7, the method further comprising.
adding a plurality of subsequent layers of material to the first layer (330) wherein each subsequent layer of material has a lower concentration of the first material than the previously added layer.

10. The method of claim 9, wherein the first layer (330) to the second layer (340) there is a gradient change in any one of grain size, grain texture, material composition, or material component density.

11. The method of claim 9, wherein each layer of the plurality of subsequent layers of material is from about 0.5 millimeter to about 3 millimeters thick.

12. The method of claim 7, wherein a coefficient of thermal expansion of the first layer (330) is within five hundred percent of a coefficient of thermal expansion of the sputtering target material.

13. The method of claim 7, wherein the backing plate (310) is formed from a backing plate material and wherein a coefficient of thermal expansion of the second layer (340) is within five hundred percent of a coefficient of thermal expansion of the backing plate material.

14. The method of claim 7, wherein a difference between a coefficient of thermal expansion of the first layer (330) and a coefficient of thermal expansion of the sputtering target (300) is less than a difference between the coefficient of thermal expansion of the first layer (300) and a coefficient of thermal expansion of the backing plate (310).

15. The method of claim 7, wherein the first mixture and the second mixture further include a third material.

**Patentansprüche**

1. Sputtertargetanordnung, umfassend:

ein Sputtertarget (300), das aus einem Sputtertargetmaterial gebildet ist und eine hintere Oberfläche aufweist; eine Trägerplatte (310), die eine vordere Oberfläche aufweist; und eine Zwischenschicht (320), die sich zwischen dem Target (300) und der Trägerplatte (310) erstreckt, wobei die Zwischenschicht (320) eine erste Schicht (330) in direktem Kontakt mit der hinteren Oberfläche des Sputtertargets und eine zweite Schicht (340) in direktem Kontakt mit der vorderen Oberfläche der Trägerplatte umfasst; wobei die erste Schicht (330) aus einer ersten Mischung gebildet ist, die ein erstes Material und ein zweites Material enthält und eine höhere Konzentration des ersten Materials als des zweiten Materials aufweist, und wobei die zweite Schicht (340) aus einer zweiten Mischung gebildet ist, die das erste Material und das zweite Material enthält und eine höhere Konzentration des zweiten Materials als des ersten Materials aufweist; wobei das erste Material und das zweite Material jeweils in der gesamten Zwischenschicht (320) vorhanden sind.

2. Sputtertargetanordnung nach Anspruch 1, wobei die Zwischenschicht (320) einen funktionalen Materialgradienten in Bezug auf Korngröße, Korntextur, Materialzusammensetzung oder Materialkomponentendichte entlang einer Achse aufweist, die sich durch das Sputtertarget (300) und die Trägerplatte (310) erstreckt, wobei die Achse senkrecht auf die hintere Oberfläche des Sputtertargets (300) steht.

3. Sputtertargetanordnung nach Anspruch 1, wobei die erste Schicht (330) und die zweite Schicht (340) jeweils zwischen etwa 0,5 Millimeter und etwa 3 Millimeter aufweisen.

4. Sputtertargetanordnung nach Anspruch 1, wobei der Wärmeausdehnungskoeffizient der ersten Schicht (330) innerhalb von fünfhundert Prozent des Wärmeausdehnungskoeffizienten des Sputtertargetmaterials liegt.

5. Sputtertargetanordnung nach Anspruch 1, wobei die Zwischenschicht (320) ferner ein drittes Material einschließt.

6. Sputtertargetanordnung nach Anspruch 1, wobei die Zwischenschicht (320) ferner ein drittes Material umfasst und wobei die erste Schicht (330) eine höhere Konzentration des dritten Materials aufweist als die zweite Schicht (340).

7. Verfahren zur Herstellung einer Sputtertargetanordnung, wobei das Verfahren umfasst:

Bilden einer ersten Schicht (330) auf einer Oberfläche eines Sputtertargets (300), das aus einem Sputtertargetmaterial gebildet ist, oder einer Oberfläche eines Trägertargets (310) aus einer ersten Mischung, die ein erstes Material und ein zweites Material enthält; Bilden einer zweiten Schicht (340) auf der ersten Schicht (330) aus einer zweiten Mischung, die das erste Material und das zweite Material enthält, wobei die erste Schicht (330) eine höhere Konzentration des ersten Materials aufweist als die zweite Schicht (340), und die zweite Schicht (340) eine höhere Konzentration des zweiten Materials aufweist als die erste Schicht (330); Anordnen der Trägerplatte (310) oder des Sputtertargets (300) auf der zweiten Schicht (340) zur Bildung einer Anordnung, die die erste Schicht (330) und die zweite Schicht (40) zwischen dem Sputtertarget (300) und der Trägerplatte (310) aufweist; und Verbinden des Sputtertargets (300), der ersten Schicht (330), der zweiten Schicht (340) und der Trägerplatte (310) miteinander in einem Klebeschritt der Targetanordnung.

8. Verfahren nach Anspruch 7, wobei die erste Schicht (330), die mindestens ein erstes Material und ein zweites Material aufweist, auf der Oberfläche der Trägerplatte (310) ausgebildet ist und das Sputtertarget (300) auf der Oberfläche der zweiten Schicht (340) angeordnet ist.

9. Verfahren nach Anspruch 7, wobei das Verfahren ferner umfasst. Hinzufügen einer Vielzahl von aufeinanderfolgenden Materialschichten zu der ersten Schicht (330), wobei jede aufeinanderfolgende Materialschicht eine geringere Konzentration des ersten Materials aufweist als die zuvor hinzugefügte Schicht.

10. Verfahren nach Anspruch 9, wobei von der ersten Schicht (330) zur zweiten Schicht (340) eine Gradientenänderung der Korngröße, der Korntextur, der Materialzusammensetzung oder der Materialkomponentendichte vorliegt.

11. Verfahren nach Anspruch 9, wobei jede Schicht der Vielzahl von aufeinanderfolgenden Materialschichten zwischen etwa 0,5 Millimeter und etwa 3 Millimeter dick ist.

**12.** Verfahren nach Anspruch 7, wobei ein Wärmeausdehnungskoeffizient der ersten Schicht (330) innerhalb von fünfhundert Prozent eines Wärmeausdehnungskoeffizienten des Sputtertargetmaterials liegt.

**13.** Verfahren nach Anspruch 7, wobei die Trägerplatte (310) aus einem Trägerplattenmaterial gebildet ist und wobei ein Wärmeausdehnungskoeffizient der zweiten Schicht (340) innerhalb von fünfhundert Prozent eines Wärmeausdehnungskoeffizienten des Trägerplattenmaterials liegt.

**14.** Verfahren nach Anspruch 7, wobei die Differenz zwischen einem Wärmeausdehnungskoeffizienten der ersten Schicht (330) und einem Wärmeausdehnungskoeffizienten des Sputtertargets (300) kleiner ist als die Differenz zwischen dem Wärmeausdehnungskoeffizienten der ersten Schicht (300) und einem Wärmeausdehnungskoeffizienten der Trägerplatte (310).

**15.** Verfahren nach Anspruch 7, wobei die erste Mischung und die zweite Mischung ferner ein drittes Material einschließen.

**Revendications**

**1.** Ensemble formant cible de pulvérisation comprenant :

une cible (300) de pulvérisation formée à partir d'une matière cible de pulvérisation et comportant une surface arrière ;
une plaque de support (310) comprenant une surface avant ; et
une couche intermédiaire (320) s'étendant entre la cible (300) et la plaque de support (310), la couche intermédiaire (320) comprenant une première couche (330) en contact direct avec la surface arrière de la cible de pulvérisation, et une seconde couche (340) en contact direct avec la surface avant de la plaque de support ;
dans lequel la première couche (330) est formée d'un premier mélange contenant une première matière et une deuxième matière et comprenant une concentration de la première matière supérieure à sa concentration dans la deuxième matière, et dans lequel la seconde couche (340) est formée d'un second mélange contenant la première matière et la deuxième matière et comprenant une concentration de la deuxième matière supérieure à sa concentration dans la première matière ;
dans lequel la première matière et la deuxième matière sont respectivement présentes dans toute la couche intermédiaire (320).

**2.** Ensemble formant cible de pulvérisation selon la revendication 1, dans lequel la couche intermédiaire (320) présente un gradient de matière fonctionnel de l'une quelconque parmi la taille de grain, la texture de grain, la composition de matière ou la densité de composant de matière le long d'un axe s'étendant à travers la cible (300) de pulvérisation et la plaque de support (310), l'axe étant perpendiculaire à la surface arrière de la cible (300) de pulvérisation.

**3.** Ensemble cible de pulvérisation selon la revendication 1, dans lequel la première couche (330) et la seconde couche (340) mesurent respectivement d'environ 0,5 millimètre à environ 3 millimètres.

**4.** Ensemble cible de pulvérisation selon la revendication 1, dans lequel le coefficient de la dilatation thermique de la première couche (330) est dans les limites de cinq cents pour cent du coefficient de dilatation thermique de la matière cible de pulvérisation.

**5.** Ensemble formant cible de pulvérisation selon la revendication 1, dans lequel la couche intermédiaire (320) comprend en outre une troisième matière.

**6.** Ensemble formant cible de pulvérisation selon la revendication 1, dans lequel la couche intermédiaire (320) comprend en outre une troisième matière et dans lequel la première couche (330) présente une concentration de la troisième matière supérieure à sa concentration dans la seconde couche (340).

**7.** Procédé de formage d'un ensemble formant cible de pulvérisation, le procédé comprenant :

la formation d'une première couche (330) sur une surface d'une cible (300) de pulvérisation formée d'une matière cible de pulvérisation ou d'une surface d'une cible de support (310) à partir d'un premier mélange contenant une première matière et une deuxième matière ;

le formage d'une seconde couche (340) sur la première couche (330) à partir d'un second mélange contenant la première matière et la deuxième matière, la première couche (330) comprenant une concentration de la première matière supérieure à sa concentration dans la seconde couche (340), et la seconde couche (340) présentant une concentration de la deuxième matière supérieure à sa concentration dans la première couche (330) ;

l'agencement de la plaque de support (310) ou de la cible (300) de pulvérisation sur la seconde couche (340) pour former un ensemble comprenant la première couche (330) et la seconde couche (40) entre la cible (300) de pulvérisation et la plaque de support (310) ; et

l'assemblage de la cible de pulvérisation (300), de la première couche (330), de la seconde couche (340) et de la plaque de support (310) dans une étape de liaison de l'ensemble formant cible.

8. Procédé selon la revendication 7, dans lequel la première couche (330) comprenant au moins une première matière et une deuxième matière est formée sur la surface de la plaque de support (310), et la cible (300) de pulvérisation est agencée sur la surface de la seconde couche (340).

9. Procédé selon la revendication 7, le procédé comprenant en outre :
l'ajout d'une pluralité de couches subséquentes de matière à la première couche (330) dans lequel chaque couche subséquente de matière présente une concentration inférieure de la première matière que la couche précédemment ajoutée.

10. Procédé selon la revendication 9, dans lequel de la première couche (330) à la seconde couche (340) il y a un changement de gradient dans l'une quelconque parmi la taille de grain, la texture de grain, la composition de matière ou la densité de composant de matière.

11. Procédé selon la revendication 9, dans lequel chaque couche de la pluralité de couches subséquentes de matière présente une épaisseur d'environ 0,5 millimètre à environ 3 millimètres.

12. Procédé selon la revendication 7, dans lequel un coefficient de dilatation thermique de la première couche (330) est dans les limites de cinq cents pour cent d'un coefficient de dilatation thermique de la matière cible de pulvérisation.

13. Procédé selon la revendication 7, dans lequel la plaque de support (310) est formée à partir d'une matière de plaque de support et dans lequel le coefficient de dilatation thermique de la seconde couche (340) est dans les limites de cinq cents pour cent du coefficient de dilatation thermique de la matière de plaque de support.

14. Procédé selon la revendication 7, dans lequel une différence entre un coefficient de dilatation thermique de la première couche (330) et un coefficient de dilatation thermique de la cible (300) de pulvérisation est inférieure à une différence entre le coefficient de dilatation thermique de la première couche (300) et un coefficient de dilatation thermique de la plaque de support (310).

15. Procédé selon la revendication 7, dans lequel le premier mélange et le second mélange comprennent en outre une troisième matière.

*FIG. 1*

*FIG. 2*

*FIG. 3*

FIG. 4

FIG. 5

XYZ movement of head

*FIG. 6*

XYZ movement of head

*FIG. 7*

EP 3 436 618 B1

XYZ movement of head

*FIG. 8*

24

FIG. 9

FIG. 10

FIG. 11

FIG. 12

*FIG. 13*

*FIG. 14*

200

202

204

206

208

Final
Machining

*FIG. 15A*

220

222

224

226

228

Final
Machining

*FIG. 15B*

*FIG. 16*

FIG. 17

*FIG. 18*

*FIG. 19*

FIG. 20a          FIG. 20b

*FIG. 21*

*FIG. 22*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0006793 A1
- US 2006065517 A1
- US 6619537 B1